# EUROPÄISCHE PATENTANMELDUNG

(11) **EP 1 039 583 A2**
(43) Veröffentlichungstag der Anmeldung: **27.09.2000**
(21) Anmeldenummer: 00104036.9
(22) Anmeldetag: 26.02.2000
(51) Int. Cl.: H01R 12/08, H05K 7/14

(54) **Signalverarbeitungseinheit**

(30) Priorität: 26.03.1999 DE 19913932
(71) Anmelder: STN ATLAS Elektronik GmbH, 28309 Bremen (DE)
(72) Erfinder: Renken, Klaus, 28857 Syke (DE); Schröder, Rainer, 28790 Schwanewede (DE)

(57) **Zusammenfassung**

Eine Signalverarbeitungseinheit weist eine Busplatine (10) mit standardisiertem Datenbus und Steckplätzen (11, 12) zum Aufstecken von Baugruppenträgern und für die Bereitstellung zusätzlicher Transferleistung eine Zusatzplatine (13) auf, die eine integrierte Sonderverdrahtung und eine Mehrzahl von in Steckplätze (12) der Busplatine (10) einsteckbaren, voneinander beabstandet aufgereihten Steckerleisten (14) trägt. Zwecks Gestaltung der Zusatzplatine (13) derart, daß sie ohne Beschädigungsgefahr mit relativ geringem Kraftaufwand auf die Busplatine (10) aufgesteckt und von der Busplatine (10) wieder abgelöst werden kann, sind zumindest die zwischen den Steckerleisten (14) sich befindlichen Abschnitte (15) der Zusatzplatine (13) flexibel ausgebildet. Dadurch kann die Zusatzplatine (13) über die Busplatine (10) quasi gerollt werden, und die Steckerleisten (14) können einzeln gesteckt werden.

## Beschreibung

Die Erfindung betrifft eine Signalverarbeitungseinheit der im Oberbegriff des Anspruch 1 definierten Gattung.

Im kommerziellen Elektroniksektor erlauben standardisierte Bussysteme, wie VME und CompactPCI, die Realisierung von modularen und industriell tauglichen Systemlösungen von Signalverarbeitungseinheiten. Schnittstellen-Baugruppen zum Aufstecken auf die Busplatine gestatten die Adaption an kundenspezifische Datenschnittstellen für den Anschluß an Peripheriegeräte. Für die Verteilung von Daten in einem VME- oder CompactPCI-Baugruppenträger kann oftmals nicht der Systembus (VIM- oder KompaktPCI-Bus) benutzt werden, weil Datenraten, Echtzeitanforderungen und andere Anforderungen von den Systembussen nicht erfüllt werden können.

Um neben dem standardisierten Systembus die spezifischen Signale im Baugruppenträger zu verteilen, hat man früher eine spezifische Verdrahtung auf den Steckplätzen der Busplatine in Wire-Wrap-Technik ausgeführt. Diese Technik ist bei heutigen, hochfrequenten Signalen aus Gründen der übertragungssicherheit gegen elektrisches Rauschen, Reflexionen und Übersprechen nicht mehr möglich. Alternativ hat man als Kaufteile erhältliche sog. Standard-Backplane mit einer zusätzlichen Frontverkabelung der Peripheriesignale verwendet. Allerdings ist diese Methode nicht überall einsetzbar, z.B. dann nicht, wenn geringe Zeitvorgaben für die Reparatur den Aufbau komplexer Frontverkabelungen verbieten oder wenn die Signale sehr hochfrequent sind, so daß Flachbandkabel aus Impedanzgründen oder wegen Abstrahlkriterien nicht eingesetzt werden können. Auch können mechanische Einbaurichtlinien den Einsatz von Frontverkabelungen verhindern.

Um diese Nachteile zu vermeiden, hat man bereits vorgeschlagen, eine Busplatine mit Standard-Bussystem mit einer Zusatzplatine, einer sog. Zusatz-Backplane, zu versehen, die die kundenspezifische Verdrahtung enthält und auf die Steckerplätze (bei VME-Bus im Bereich des P2-Steckers) aufgesteckt wird. Hochfrequente Signale können so durch die kontrollierte Impedanz des übertragungswegs und durch geeignete Abschirmungsmaßnahmen im Baugruppenträger verteilt werden. Außerdem kann das Design der Zusatzplatine einfach gestaltet und damit vermehrter Herstellungsaufwand vermieden werden.

Der Realisierung solcher Zusatzplatinen sind aber mechanische Grenzen gesetzt. Soll die Zusatzplatine mehrere Steckplätze überdecken, so steigt der Kraftaufwand, der für das Stecken bzw. das Ziehen aufgebracht werden muß. Soll eine Zusatzplatine beispielsweise etwa zehn Steckplätze überspannen, so sind Kräfte von ca. 1500 N notwendig. Solche Steck- und Ziehkräfte sind manuell nicht zu beherrschen, so daß Vorrichtungen verwendet werden müssen, die eine gleichmäßige Führung beim Steckvorgang gewährleisten und eine flächige Aufnahme der Spannbacken gestatten. Der Kraftfluß muß gleichförmig zwischen der kraftgebenden Seite und der kräfteabführenden Seite gehalten werden, da andernfalls mit einer Zerstörung des Epoxid-Materials der Busplatine zu rechnen ist oder die Kupferleiterbahnen mechanisch so beansprucht werden, daß es zum Abriß von Leiterbahnen kommen kann. Somit muß die Zusatzplatine vor dem Einbau in den Baugruppenträger gesteckt werden. Ein nachträgliches Stecken ist in der Regel wegen Platzproblemen und der Gefahr von Beschädigungen nicht möglich. Ist die Zusatzplatine erst einmal gesteckt, so läßt sie sich ohne mechanische Vorrichtungen nicht wieder ablösen. Und auch hierbei ist die Zerstörungsgefahr groß.

Eine bekannte Steckkartenanordnung (US 52 59 784 A) weist vertikal ausgerichtete Steckkarten auf, die zu einem ersten und zweiten Steckkartensatz zusammengestellt jeweils mit ihrer unteren Kartenkante in auf einer horizontal ausgerichteten Trägerplatine vorhandenen Einschubleisten eingeschoben sind. Die Steckkarten eines jeden Steckkartensatzes sind parallel zueinander und im Abstand voneinander ausgerichtet, und die beiden horizontalen Trägerplatinen mit je einem Steckkartensatz sind in der Horizontalebene um 90° gegeneinander verdreht. Jede Steckkarte trägt mehrere Steckleisten, die in auf je einer rechtwinklig zu den Steckkarten vertikal ausgerichteten Platine angeordnete Steckplätze einsteckbar sind. Alle Steckkarten und Platinen sind steif ausgebildet.

Bei einer bekannten Anordnung zur wechselseitigen elektrischen Verbindung einer Mehrzahl von einen Verbund bildenden gedruckten Leiterplatten, die jeweils mit als Verbindungsleisten ausgebildeten Steckverbindern ausgestattet sind, ist zwecks Verbindung möglichst vieler Bauelemente benachbarter Leiterplatten über möglichst kurze Leitunyszüge ein Teil der Leiterplatten mit wenigstens zwei an unterschiedlichen Seiten angeordneten Steckverbindern derart versehen, daß die Gesamtheit der Steckverbinder in wenigstens zwei zueinander nicht parallelen Ebenen angeordnet ist (DE 23 20 202 A1).

Ein bekannter Leiterplattenverbindungsaufbau (DD 256 038 A1) besteht aus einer oder mehreren mit Bauelementen bestückten Funktionsleiterplatten und einer oder mehreren mit Busleitungszügen und Lötaugen versehenen Rückverdrahtungsleiterplatten. Zwecks Erhöhung der Packungsdichte elektronischer Bauelemente durch Vermeiden von Verbindungsleiterzügen auf den Funktionsleiterplatten wird die Lage der Lötaugen auf den Busleitungszügen durch ein vom Anwender gewähltes Raster bestimmt, wobei die Rückverdrahtungsleiterplatte gleichzeitig die Funktion eines Trägerelements der Funktionsleiterplatte übernimmt.

Bei einer bekannten Steckerplatte mit in einem orthogonalen Raster auf der einen Verbauseite der Steckerplatte angeordneten Federleisten zur Aufnahme von Baugruppenträgern (DE 24 24 764 A1) ragen die Steckerstifte der Federleisten durch in die Steckerplatte eingearbeitete Durchbrüche hindurch und über die Ebene der zweiten Verbauseite der Steckerplatte hinaus. Die Baugruppenträger sind untereinander und mit der Peripherie verdrahtet, um die elektrische Verbindung für die Signal- und Stromversorgungsleitungen herzustellen. Der Verdrahtungsaufbau erfolgt dabei mit unterschiedlichen Verdrahtungstechniken. Zur Erzielung eines Verdrahtungskonzeptes, das übersichtlich ist, die Funktionsprüfung und die Suche nach Verteilungsfehlern erleichtert, sind jeweils Steckerstifte der verschiedenen Federleisten entsprechend einem für Steckerplatten eines bestimmten Typs identischen Muster paarweise miteinander elektrisch leitend verbunden. Bevorzugt erfolgt die paarweise Verbindung der Steckerstifte auf der Rückseite der Steckerplatte durch Leitungsstücke.

Der Erfindung liegt die Aufgabe zugrunde, bei einer Signalverarbeitungseinheit der eingangs genannten Art die Zusatzplatine oder Zusatz-Backplane so zu gestalten, daß sie ohne Beschädigungsgefahr mit relativ geringem Kraftaufwand auf die Busplatine aufgesteckt und von der Busplatine wieder abgezogen werden kann.

Die Aufgabe ist durch die Merkmale des Anspruchs 1 gelöst.

Die erfindungsgemäße Signalverarbeitungseinheit hat den Vorteil, daß die Zusatzplatine oder Backplane durch die Flexibilität der zwischen den Steckerleisten verbleibenden Abschnitte eine solche Elastizität erhält, daß sie biegefähig ist. Dadurch können die Steckerleisten einzeln nacheinander auf die Steckplätze aufgesteckt werden, wobei die Zusatzplatine sozusagen über die Steckplätze abgerollt wird. Die Aufpreßkraft bzw. die Abziehkraft muß jeweils nacheinander nur noch in einem Teilbereich der Zusatzplatine - und nicht mehr gleichzeitig auf die gesamte Zusatzplantine - aufgebracht werden und beschränkt sich auf den Bereich einer einzelnen Steckerleiste. Bei einem VME 64- Extension Steckplatz ist die jeweils erfoderliche Aufpress- oder Abziehkraft damit kleiner als 150 N, selbst wenn die gesamte Zusatzplatine mehrere Steckplätze, z.B. zehn, überspannt.

Zweckmäßige Ausführungsformen der erfindungsgemäßen Signalverarbeitungseinheit mit vorteilhaften Weiterbildungen und Ausgestaltungen der Erfindung ergeben sich aus den weiteren Ansprüchen.

Die Erfindung ist anhand eines in der Zeichnung dargestellten Ausführungsbeispiels im folgenden näher beschrieben. Es zeigen :
- Fig. 1: ausschnittweise eine perspektivische Darstellung einer Signalverarbeitungseinheit mit Busplatine und Zusatzplatine,
- Fig. 2: ausschnittweise eine Ansicht der Zusatzplatine in Richtung Pfeil II in Fig. 1, teilweise geschnitten,
- Fig. 3: ausschnittweise eine Ansicht der Zusatzplatine in Richtung Pfeil III in Fig. 1

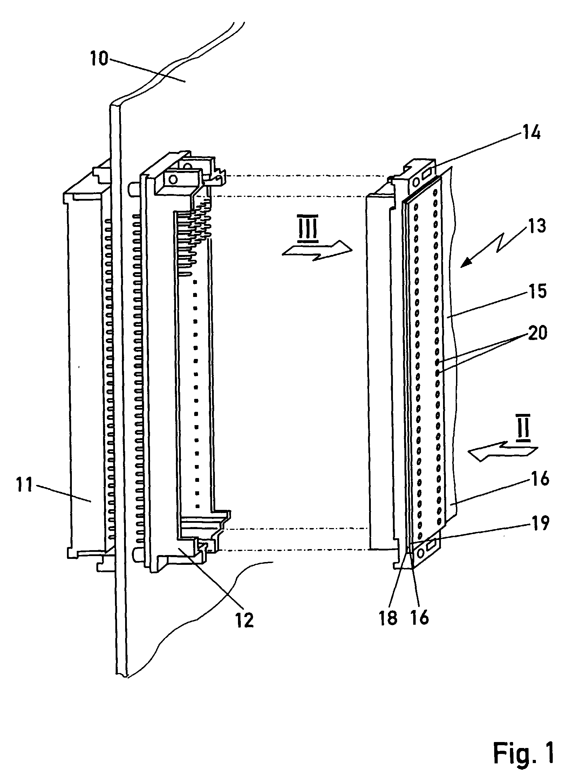

Die in Fig. 1 ausschnittweise dargestellte Signalverarbeitungseinheit, beispielsweise ein Arrayprozessor, weist eine Busplatine 10 mit integriertem, standardisiertem Datenbus auf, die eine Vielzahl von Steckplätzen 11, 12 zum Aufstecken von beliebigen Baugruppenträgern trägt. Von der Vielzahl der Steckplätze 11 und 12 sind in Fig. 1 jeweils nur ein Steckplatz 11 und ein Steckplatz 12 dargestellt. Da bei Signalverarbeitungseinheiten, in denen für die Kommunikationsleistung ein besonderes Transferprofil notwendig ist, der Standardbus (z.B. VME-Bus), nicht ausreicht, wird die zusätzliche Transferleistung über eine Zusatzplatine 13, auch Backplane genannt, mit integrierter Sonderverdrahtung hergestellt. Diese Zusatzplatine 13 trägt eine Mehrzahl von Steckerleisten 14, die voneinander beabstandet aufgereiht und zum Aufstecken auf die Steckplätze 12 adaptiert sind.

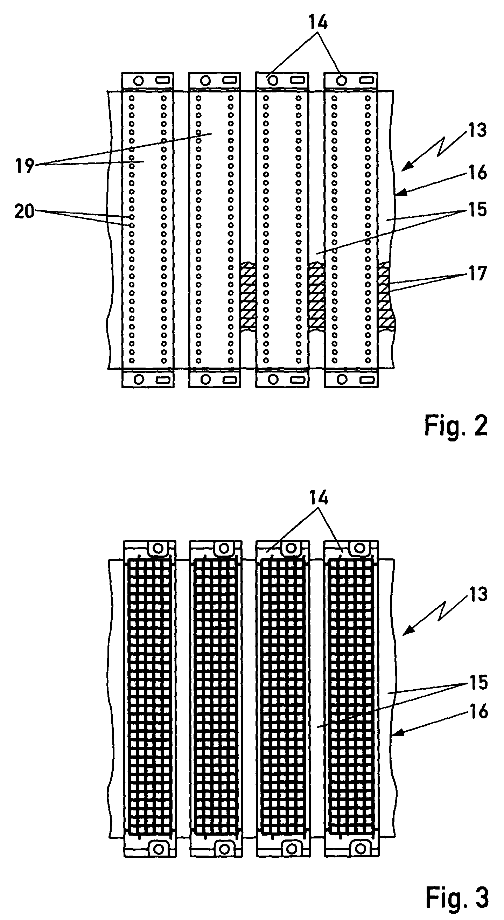

In Fig. 1 ist eine solche Zusatzplatine 13 mit nur einer Steckerleiste 14 perspektivisch dargestellt. Ein vergrößerter Abschnitt der Zusatzplatine 13 mit insgesamt vier Steckerleisten 14 ist in Fig. 2 in Rückansicht und in Fig. 3 in Vorderansicht entsprechend den Ansichtspfeilen II und III in Fig. 1 dargestellt.

Um die Aufsteckkräfte zum Aufstecken der Zusatzplatine 13 auf die Busplatine 10 in Grenzen zu halten, und ebenso die Abziehkräfte, sind die zwischen den Steckerleisten 14 befindlichen Abschnitte 15 der Zusatzplatine 13 flexibel ausgebildet. Dadurch erhält die Zusatzplatine 13 soviel Elastizität, daß sie biegefähig wird und beim Einbau sozusagen über die Steckplätze 12 abgerollt werden kann. Dadurch kann eine Steckerleiste 14 nach der anderen einzeln gesteckt werden, wozu eine Steckkraft bzw. eine Abziehkraft von kleiner als 150 N erforderlich ist.

Diese Flexibilität der zwischen den Steckerleisten 14 sich befindlichen Abschnitte 15 wird dadurch erreicht, daß die Zusatzplatine 13 ein über die Mehrzahl der Steckerleisten 14 hinwegeführtes, filmartig dünnes, flexibles Breitband 16 mit darin eingebetteten, parallelen Leiterbahnen 17 (Fig. 2) aufweist, das im Bereich der Steckerleisten 14 zwischen zwei steifen Kunststoffplatten 18, 19, z.B. aus Epoxid, eingespannt ist. Auf der Kunststoffplatte 18 liegt dann die Steckerleiste 14 auf, deren Kontakte 20 durch die Kunststoffplatte 18, das flexible Breitband 16 und die Kunststoffplatte 19 hindurchgeführt sind, so daß sie auch auf der Kunststoffplatte 19 kontaktiert werden können. Durch diese Kunststoffplatten 18, 19 erhält die Zusatzplatine 13 die erforderliche mechanische Festigkeit im Bereich der Steckerleisten 14 und kann damit mechanisch stabil gesteckt und gezogen werden. Die Breite des Breitbands 16 entspricht der Länge der Steckerleisten 14, und die Abmessungen der Kunststoffplatte 18, 19 entsprechen denen der Grundfläche der jeweils zugeordneten Steckerleiste 14.

Die Zusatzplatine 13 wird in einer standardisierten Länge mit einer standardisierten Zahl von Steckerleisten 14 gefertigt. Ist zur Belegung einer Busplatine 10 mit einer Zusatzplatine 13 eine geringere Anzahl von Steckerleisten 14 erforderlich, so wird die Zusatzplatine 13 auf die benötigte Länge zugeschnitten, in dem das flexible Breitband 16 mit integrierten Leiterbahnen 17 innerhalb des passenden flexiblen Abschnitts 15 zwischen zwei Steckerleisten 14 durchtrennt wird.

## Patentansprüche

1. Signalverarbeitungseinheit mit einer Busplatine (10), die einen standardisierten Datenbus und Steckplätze (11, 12) zum Aufstecken von Baugruppenträgern aufweist, und mit einer Zusatzplatine (13), die eine integrierte Sonderverdrahtung und eine Mehrzahl von in Steckplätze (12) der Busplatine (10) einsteckbaren, voneinander beabstandet aufgereihten Steckerleisten (14) trägt, dadurch gekennzeichnet, daß zumindest die zwischen den Steckerleisten (14) sich befindlichen Abschnitte (15) der Zusatzplatine (13) flexibel ausgebildet sind.

2. Einheit nach Anspruch 1, dadurch gekennzeichnet, daß die im Bereich der Steckerleisten (14) sich befindlichen Abschnitte (15) der Zusatzplatine (13) eigensteif ausgebildet sind.

3. Einheit nach Anspruch 2, dadurch gekennzeichnet, daß die Zusatzplatine (13) ein über die Mehrzahl der Steckerleisten (14) hinweggeführtes, filmartig dünnes, flexibles Breitband (16) mit darin eingebetteten Leiterbahnen (17) aufweist, das im Breich der Steckerleisten (14) zwischen zwei steifen Kunststoffplatten (18, 19) eingespannt ist, von denen eine die Steckerleiste (14) trägt.

4. Einheit nach Anspruch 3, dadurch gekennzeichnet, daß die Breite des Breitbands (16) etwa der Länge der Steckerleisten (14) entspricht.

5. Einheit nach Anspruch 3 oder 4, dadurch gekennzeichnet, daß die Abmessungen der Kunststoffplatten (18, 19) etwa denen der Grundfläche der Steckerleisten (14) entsprechen.

6. Einheit nach einem der Ansprüche 1 bis 5, dadurch gekennzeichnet, daß die Zusatzplatine (13) eine standardisierte Länge mit einer standardisierten Zahl von Steckerleisten (14) aufweist und daß die zum Aufstecken auf die Steckplätze (12) der Busplatine (10) benötigte Zahl von Steckerleisten (14) von der standardisierten Länge durch Durchtrennen des Breitbands (16) im Bereich eines flexiblen Abschnitts (15) abschneidbar ist.
